(19) **Europäisches Patentamt / European Patent Office / Office européen des brevets**

(11) **EP 4 478 482 A1**

(12) **EUROPEAN PATENT APPLICATION**
published in accordance with Art. 153(4) EPC

(43) Date of publication:
**18.12.2024 Bulletin 2024/51**

(21) Application number: **23749848.0**

(22) Date of filing: **03.02.2023**

(51) International Patent Classification (IPC):
**H01M 10/48** (2006.01)     **G01R 31/367** (2019.01)
**G01R 31/392** (2019.01)     **H01M 10/44** (2006.01)

(52) Cooperative Patent Classification (CPC):
**G01R 31/367; G01R 31/392; H01M 10/44;
H01M 10/48;** Y02E 60/10

(86) International application number:
**PCT/JP2023/003516**

(87) International publication number:
**WO 2023/149532 (10.08.2023 Gazette 2023/32)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 07.02.2022  JP 2022017035
21.04.2022  JP 2022069863
21.04.2022  JP 2022070009
21.04.2022  JP 2022069870

(71) Applicant: **Maxell, Ltd.
Kyoto 618-8525 (JP)**

(72) Inventors:
• **KISHIMI, Yuko
Otokuni-gun, Kyoto 618-8525 (JP)**
• **MATSUMOTO, Nobuaki
Otokuni-gun, Kyoto 618-8525 (JP)**

(74) Representative: **Mewburn Ellis LLP
Aurora Building
Counterslip
Bristol BS1 6BX (GB)**

(54) **SECONDARY BATTERY DIAGNOSTIC METHOD AND SECONDARY BATTERY DIAGNOSTIC PROGRAM**

(57)     Provided is a secondary battery diagnostic method that can evaluate a remaining life of a secondary battery more accurately than in the related art without disassembly of the secondary battery. The secondary battery diagnostic method includes estimating characteristic parameters of a secondary battery to be diagnosed at a time of diagnosis (step S 1), obtaining a relationship between an electrolyte diffusion coefficient and a discharge capacity (step S2), determining, on the basis of the relationship between the electrolyte diffusion coefficient and the discharge capacity, a threshold value Dth of the electrolyte diffusion coefficient (step S3), and obtaining a difference $\Delta D$ between the threshold value Dth and an electrolyte diffusion coefficient Dn at the time of diagnosis (step S4).

FIG. 1

**Description**

Technical Field

The present invention relates to a secondary battery diagnostic method and a secondary battery diagnostic program.

Background Art

A secondary battery such as a lithium ion battery gradually decreases in discharge capacity with repeated charging and discharging. Therefore, the secondary battery is preferably diagnosed at an appropriate time to evaluate a degree of deterioration thereof and determine whether reuse is possible or determine a replacement period. Further, to reuse the secondary battery after diagnosis, preferably the diagnosis is performed in a non-destructive manner.

JP 2017-97997 A describes a characteristic analysis method for a secondary battery in which a model equation, parameters of which are characteristic values of members constituting the battery, is used, and the characteristic values of the member are estimated by fitting a voltage value of the battery represented by the model equation with actual measurement data. In this characteristic analysis method, the actual measurement data used is obtained by applying a charge/discharge pattern to the battery under analysis, which includes an operation period consisting of either a constant current discharge period or a constant current charge period, followed by a rest period.

Further, the publication describes, as the characteristic values estimated by the fitting with the actual measurement data, a lithium ion diffusion coefficient in a positive electrode active material, a lithium ion diffusion coefficient in a negative electrode active material, a lithium ion diffusion coefficient in an electrolyte (electrolyte diffusion coefficient), an interface resistance in the positive electrode active material, an interface resistance in the negative electrode active material, a lithium ion salt concentration in the electrolyte, and the like.

Citation List

Patent Literature

Patent Document 1: JP 2017-97997 A

Summary of Invention

Technical Problem

In the related art, the degree of deterioration of a secondary battery is evaluated on the basis of a magnitude of discharge capacity or a magnitude of internal resistance at the time of diagnosis. However, according to research conducted by the present inventors, it has been found that, even if the magnitudes of discharge capacity and the magnitudes of internal resistance at the time of diagnosis are substantially the same, the numbers of times that secondary batteries can be used thereafter are not necessarily substantially the same. Specifically, among secondary batteries having substantially the same magnitudes of discharge capacity and magnitudes of internal resistance at the time of diagnosis, there exist secondary batteries in which the discharge capacity drops sharply after a small number of charge/discharge cycles, secondary batteries in which the discharge capacity does not substantially drop even after charging/discharging, and the like. As a result, a remaining life of the secondary battery cannot be accurately evaluated by measuring only the magnitude of discharge capacity and the magnitude of internal resistance at the time of diagnosis.

The aforementioned JP 2017-97997 A describes a method for estimating characteristic values of members constituting a secondary battery without disassembly of the secondary battery. However, this publication does not describe a specific method for evaluating the remaining life of the secondary battery from these characteristic values.

An object of the present invention is to provide a secondary battery diagnostic method and a secondary battery diagnostic program that can evaluate a remaining life of a secondary battery more accurately than in the related art without disassembly of the secondary battery.

Solution to Problem

A secondary battery diagnostic method according to an embodiment of the present invention includes estimating, on the basis of data obtained by measuring load characteristics of a secondary battery to be diagnosed, characteristic parameters of the secondary battery to be diagnosed at a time of diagnosis by using a predetermined model equation, the characteristic parameters including an electrolyte diffusion coefficient $D_n$ of the secondary battery to be diagnosed at the time of diagnosis; obtaining, on the basis of the model equation and the characteristic parameters estimated, a discharge capacity when an electrolyte diffusion coefficient is changed, and obtaining a relationship between the electrolyte diffusion coefficient and the discharge capacity; determining, on the basis of the relationship between the electrolyte diffusion coefficient and the discharge capacity, a threshold value Dth of the electrolyte diffusion coefficient; and obtaining a difference ΔD between the threshold value Dth and the electrolyte diffusion coefficient Dn at the time of diagnosis.

A secondary battery diagnostic program according to an embodiment of the present invention is a secondary battery diagnostic program for causing a computer to execute estimating, on the basis of data obtained by measuring load characteristics of a secondary battery to be diagnosed, characteristic parameters of the secondary battery to be diagnosed at a time of diagnosis by using a predetermined model equation, the characteristic parameters including an electrolyte diffusion coefficient Dn of the secondary battery to be diagnosed at the time of diagnosis; obtaining, on the basis of the model equation and the characteristic parameters estimated, a discharge capacity when an electrolyte diffusion coefficient is changed, and obtaining a relationship between the electrolyte diffusion coefficient and the discharge capacity; determining, on the basis of the relationship between the electrolyte diffusion coefficient and the discharge capacity, a threshold value Dth of the electrolyte diffusion coefficient; and obtaining a difference ΔD between the threshold value Dth and the electrolyte diffusion coefficient Dn at the time of diagnosis.

Advantageous Effects of Invention

According to the present invention, it is possible to evaluate a remaining life of a secondary battery more accurately than in the related art without disassembly of the secondary battery.

Brief Description of Drawings

FIG. 1 is a flowchart of a secondary battery diagnostic method according to a first embodiment of the present invention.
FIG. 2 is a flowchart illustrating an example of a more specific procedure of a process of estimating characteristic parameters.
FIG. 3 is a graph showing an example of a relationship between an electrolyte diffusion coefficient and a discharge capacity.
FIG. 4 is a graph showing an example of how to determine a threshold value Dth.
FIG. 5 is a flowchart illustrating a more specific procedure of a process of determining the threshold value Dth of the electrolyte diffusion coefficient in the secondary battery diagnostic method according to a second embodiment of the present invention.
FIG. 6 is a graph obtained by fitting the relationship between the electrolyte diffusion coefficient and the discharge capacity shown in FIG. 3 with equation (1).
FIG. 7 is a flowchart of the secondary battery diagnostic method according to a third embodiment of the present invention.
FIG. 8 is a flowchart of the secondary battery diagnostic method according to a fourth embodiment of the present invention.
FIG. 9 shows the relationship between ΔD obtained by diagnosis and the number of cycles at the onset of a sharp drop.
FIG. 10 is a graph showing a relationship between the number of cycles and the discharge capacity of two cells (cell No. 1 and cell No. 3) in which Li deposition occurred.
FIG. 11 is a graph showing a relationship between the number of cycles and the electrolyte diffusion coefficient.
FIG. 12 is a graph showing results of a cycle test of a deteriorated cell used for estimation in FIG. 11.
FIG. 13 is a graph obtained by adding a relationship between the number of cycles and the threshold value of the electrolyte diffusion coefficient to the graph in FIG. 11.

Description of Embodiments

The present inventors focused on an electrolyte diffusion coefficient when evaluating a remaining life of a secondary battery. In the course of cycle deterioration, a secondary battery approaches a state of so-called "liquid depletion" as an electrolyte amount and a salt concentration therein decrease. It is known that, at this time, the value of the electrolyte diffusion coefficient decreases. A value Dn of the electrolyte diffusion coefficient of the secondary battery at the time of diagnosis can be estimated in a non-destructive manner by using measurement data of load characteristics and a model equation well known in this field. Further, a relationship between the electrolyte diffusion coefficient and a discharge capacity can be obtained by simulation using the model equation described above.
A value Dth of the electrolyte diffusion coefficient when the secondary battery becomes unsuitable for reuse is determined from the relationship between the electrolyte diffusion coefficient and the discharge capacity, and a difference $\Delta D = Dn - Dth$ from the value Dn of the electrolyte diffusion coefficient at the time of diagnosis is then obtained. This $\Delta D$ can be used as an index of the remaining life of the secondary battery. That is, an evaluation can be made as follows: the larger the value of $\Delta D$, the lower the likelihood early liquid depletion occurs, and the higher the likelihood the secondary battery can be used over a long period of time. Conversely, the smaller the value of $\Delta D$, the higher the likelihood early liquid depletion occurs and the lower the likelihood the secondary battery can be used over a long period of time. A method for predicting a sharp drop in discharge capacity due to such liquid depletion has been nonexistent heretofore. By using this technique, it is possible to evaluate the remaining life of a secondary battery more accurately than in the related art.

Method for Determining Threshold Value Dth of Electrolyte Diffusion Coefficient

The present inventors have further studied methods for determining the threshold value Dth of the electrolyte diffusion coefficient used in the above evaluation. Basically, the threshold value Dth can be determined as desired in accordance with the application of the secondary battery and the like. On the other hand, in terms of more reliably evaluating the reusable life, it is a reasonable approach to determine, as the threshold value Dth, the value of the electrolyte diffusion coefficient at an initial stage of onset of a sharp drop in discharge capacity, and intentionally secure a large margin.

The relationship between the electrolyte diffusion coefficient and the discharge capacity is not linear, but rather exhibits a curve in which the decrease in discharge capacity increases as the electrolyte diffusion coefficient decreases. The relationship between an electrolyte diffusion coefficient D and the discharge capacity can be accurately approximated by equation (1) below.

$$\text{Discharge capacity} = Amax - B \times EXP\ (Dh/D)\ (1)$$

Here, Amax (maximum capacity), B (decrease rate), and Dh (decrease coefficient) are parameters obtained by fitting the relationship between the electrolyte diffusion coefficient and the discharge capacity obtained by the simulation described above.

When the value of the electrolyte diffusion coefficient at the initial stage of onset of a sharp drop in discharge capacity is determined to be the threshold value Dth, the threshold value Dth may be set to a value of from 50% to 60% of Dh in equation (1) described above. While the electrolyte diffusion coefficient is in a range of from 50% to 60% of Dh, with reference to the absolute value of the discharge capacity, it can still be said that the discharge capacity is being sufficiently maintained. On the other hand, in view of the fact that the discharge capacity decreases exponentially thereafter, by defining the value of the electrolyte diffusion coefficient of this time point as the threshold value Dth, it is possible to more reliably evaluate the reusable life. Even in a case in which there is a measurement error in the data used at the time of diagnosis or a simulation error, for example, it is possible to more reliably evaluate the reusable life.

Further, a sharp drop in discharge capacity indicates that the diffusivity of the electrolyte inside the secondary battery is insufficient, and all active materials inside the electrodes are starting to become unable to contribute to reactions. When all active materials inside the electrodes can no longer contribute to reactions, the reaction is localized, increasing the likelihood of Li deposition. That is, it can be said that the time point of the onset of a sharp drop in discharge capacity is the time point at which the likelihood of Li deposition increases. Therefore, from the viewpoint of taking into consideration the likelihood of Li deposition as well, arguably the threshold value Dth is preferably determined to be a value of from 50% to 60% of Dh.

Relationship between $\Delta D$ and Number of Cycles

The life of a secondary battery greatly varies depending on usage conditions (for example, discharge rate). Therefore, the evaluation of the remaining life by $\Delta D$ described above does not necessarily mean the prediction of a specific number of charge/discharge cycles until the battery becomes unsuitable for reuse.

However, the present inventors have found that, in a secondary battery that uses a general-purpose active material such as NCM, LCO, GC, or SiO, when the secondary battery undergoes cycle deterioration under certain conditions, the electrolyte diffusion coefficient decreases substantially linearly with respect to the number of cycles. Therefore, in a case in which it is assumed that the secondary battery is used under certain conditions, the number of cycles at which the difference $\Delta D$ described above becomes zero can be predicted on the basis of a relationship between the electrolyte diffusion coefficient and the number of cycles.

In the case of cycle deterioration, as steady deterioration, a decrease in discharge capacity following the root law occurs, making it necessary to anticipate the occurrence of both this decrease and the sharp drop due to a reduction in liquid diffusivity. Until now, there has been no method for predicting, in terms of the "number" of cycles, the "sharp drop" that deviates from the root law. By using this technique, it is possible to evaluate the remaining life of a secondary battery more accurately than in the related art.

The present inventors further analyzed a deterioration state of the secondary battery in more detail in order to improve the accuracy of the prediction.

The threshold value Dth of the electrolyte diffusion coefficient described above is determined on the basis of the relationship between the electrolyte diffusion coefficient and the discharge capacity acquired from the characteristic parameters at the time of diagnosis. In this case, a change in a characteristic parameter other than the electrolyte diffusion coefficient is incorporated into a change in the electrolyte diffusion coefficient, making it possible to evaluate the remaining life by one parameter (electrolyte diffusion coefficient). In this way as well, the remaining life of the secondary battery can be evaluated with high accuracy to a certain extent. However, in an actual secondary battery, characteristic parameters other than the electrolyte diffusion coefficient also change with cycle deterioration, resulting in the possibility of occurrence of deviation between the threshold value Dth obtained from the characteristic parameters at the time of diagnosis and the actual threshold value.

The present inventors measured load characteristics of secondary batteries that had undergone cycle charge/-discharge tests under certain conditions at a plurality of time points with different numbers of cycles, and obtained the threshold value of the electrolyte diffusion coefficient from the data of the load characteristics in the same manner as described above. As a result, it was found that the threshold value of the electrolyte diffusion coefficient also changes substantially linearly with respect to the number of cycles as in the case of the electrolyte diffusion coefficient. Taking this into consideration, by predicting the time point at which the electrolyte diffusion coefficient falls below the threshold value, it is possible to obtain, with higher accuracy, the number of cycles at the onset of a sharp drop in discharge capacity.

The present invention has been completed on the basis of the above findings. Hereinafter, embodiments of the present invention will be described in detail with reference to the drawings.

Secondary Battery Diagnostic Method

First Embodiment

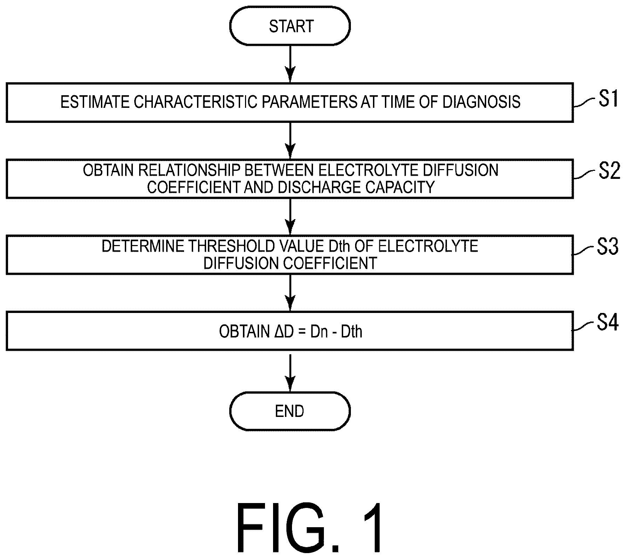

FIG. 1 is a flowchart of a secondary battery diagnostic method according to a first embodiment of the present invention. This diagnostic method includes a process of estimating characteristic parameters of a secondary battery to be diagnosed (hereinafter "target battery") at a time of diagnosis (step S 1), a process of obtaining the relationship between the electrolyte diffusion coefficient and the discharge capacity (step S2), a process of determining the threshold value Dth of the electrolyte diffusion coefficient (step S3), and a process of obtaining the difference $\Delta D$ between the threshold value Dth and the electrolyte diffusion coefficient Dn at the time of diagnosis (step S4). Hereinafter, each process will be described in detail.

Process of Estimating Characteristic Parameters

Characteristic parameters of the target battery at the time of diagnosis are estimated (step S 1). More specifically, on the basis of the data obtained by measuring the load characteristics of the target battery, the characteristic parameters of the target battery at the time of diagnosis, including the electrolyte diffusion coefficient Dn of the target battery at the time of diagnosis, are estimated by using a predetermined model equation.

In this process, characteristic parameters of the target battery at the time of diagnosis are estimated by fitting the data obtained by measuring the load characteristics of the target battery by using a predetermined model equation. This analysis (simulation) can be performed by a computer program that can perform fluid analysis, and can be performed by, for example, the software Battery Design Studio available from Siemens AG.

The model equation used can be an equation well known in this field. As the model equation, for example, the equation described in Marc Doyle et al., "Modeling of Galvanostatic Charge and Discharge of the Lithium/Polymer/Insertion Cell," J. Electrochem. Soc., Vol. 140, No. 6, June (1993) can be used.

The target battery is, for example, a lithium ion battery.

The data obtained by measuring the load characteristics of the target battery is, for example, a discharge curve obtained by measuring the target battery at a plurality of discharge rates. This data preferably includes a discharge curve obtained by measurement at an extremely low discharge rate (0.02 C, for example). Further, this data preferably includes a discharge curve obtained by measurement at a discharge rate of 1 C or higher. This data preferably includes a discharge curve obtained by measurement at discharge rates of three or more levels, and more preferably includes a discharge curve obtained by measurement at discharge rates of four or more levels. The data obtained by measuring the load characteristics of the target battery may be a charge curve obtained by measuring the target battery at a plurality of charge rates.

The characteristic parameters estimated in this process (characteristic parameters of the target battery at the time of diagnosis) include at least the electrolyte diffusion coefficient Dn of the target battery at the time of diagnosis. The characteristic parameters can include, for example, a solid-phase diffusion coefficient of positive and negative electrode active materials and an electrolyte conductivity. Other specific examples of the characteristic parameters will be described below.

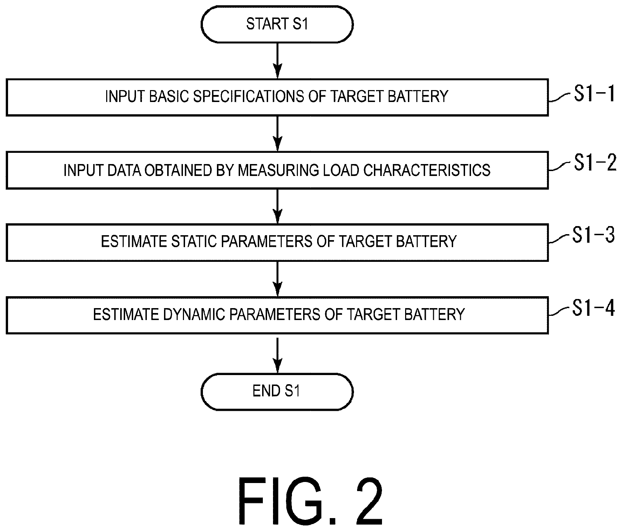

FIG. 2 is a flowchart illustrating an example of a more specific procedure of the process of estimating characteristic parameters (step S1). In this example, the process of estimating the characteristic parameters (step S1) includes a process of inputting basic specifications of the target battery (step S 1-1), a process of inputting data obtained by measuring load characteristics of the target battery (step S 1-2), a process of estimating static parameters of the target battery (step S1-3), and a process of estimating dynamic parameters of the target battery (step S1-4).

Basic specifications of the secondary battery to be diagnosed are input to the analysis software (step S1-1). The basic specifications input can include, but are not limited to, for example, the following.

   • Electrode compositions of positive and negative electrodes (constituent materials, content ratios, particle sizes, and the like)
   • Electrode thicknesses, densities, and tortuosities (approximately 1.5 in many cases) of positive and negative electrodes
   • Materials, thicknesses, and electrical conductivities of positive and negative electrode currentcollecting foils
   • Thickness and porosity of separator
   • Composition of electrolyte (constituent materials, content ratios)
   • Thermal conductivities and heat capacities of the constituent materials (basic physical property values specific to the materials)
   • Electrode area

With the diagnosis being basically performed non-destructively, accurate composition information of the electrolyte at the time of diagnosis cannot be obtained. Therefore, general information of the secondary battery to be diagnosed (or standard information of a new battery) is obtained and input as parameters. Although some values need to be input when the simulation is actually performed, the composition of the electrolyte does not significantly affect the result of the simulation. In the diagnostic method of the present embodiment, the role of the electrolyte composition information is only for reference purposes.

Although the densities of the positive and negative electrodes are also expected to change due to expansion from initial states, accurate values at the time of diagnosis cannot be measured. Therefore, an initial value (standard value or the like) or a value predicted from the initial value is input. If the value is completely unknown, a typical value may be input. If necessary, fine adjustment may be performed in step S 1-4.

The data obtained by measuring the load characteristics of the target battery is input to the analysis software (step S1-2). The data obtained by measuring the load characteristics of the target battery is, as described above, a discharge curve obtained by measuring the target battery at a plurality of discharge rates, or the like. The "data obtained by measuring the load characteristics of the target battery" is hereinafter also referred to as "actual measurement data".

The static parameters of the target battery are estimated from the actual measurement data and the model equation (step S 1-3). For example, the static parameters of the target battery are adjusted so as to match a shape of the discharge curve obtained by measurement at an extremely low discharge rate. The discharge curve obtained by measurement at an extremely low discharge rate (0.02 C, for example) can be considered to approximately coincide with a voltage curve when no load is connected (open-circuit voltage curve (OCV)). The static parameters can include, but are not limited to, for example, the following.

   • Capacities per unit weight of positive and negative electrode active materials (battery after use decreases in discharge capacity)
   • Respective utilization rates of positive and negative electrode active materials (not all regions are mutually used)
   • Maximum voltage and minimum voltage of target battery usage range

The dynamic parameters of the target battery are estimated from the actual measurement data and the model equation (step S 1-4). For example, a simulation is performed in which the target battery is discharged at a current value equivalent to that of the measurement conditions of actual measurement data, and the dynamic parameters are adjusted while comparing the data obtained by this simulation result and the actual measurement data such that the two coincide. This simulation can be performed using, for example, the discharge curve prediction of Battery Design Studio described above. The dynamic parameters may include, but are not limited to, for example, the following.

   • Electrolyte conductivity
   • Electrolyte diffusion coefficient
   • Solid phase diffusion coefficients of positive and negative electrode active materials

• Heat capacity of target battery

The ambient temperature at the time of the simulation is preferably set so as to coincide with the ambient temperature at the time of actual measurement data acquisition. In the case of a medium or larger sized product battery, particularly, a product battery assumed to be used at a high rate, preferably the influence of heat generation is taken into consideration. To achieve this, preferably measurements are performed at least at 1 C and fitting is conducted with the actual measurement data affected by heat generation. On the other hand, as long as the target battery is a small cell for a desk test or the like, the influence of heat generation need not be considered.

Through the above processes, it is possible to estimate the characteristic parameters of the target battery at the time of diagnosis, including the electrolyte diffusion coefficient $D_n$ of the target battery at the time of diagnosis.

Process of Obtaining Relationship between Electrolyte Diffusion Coefficient and Discharge Capacity

On the basis of the model equation used in step S1 and the characteristic parameters estimated in step S1, the relationship between the electrolyte diffusion coefficient and the discharge capacity is obtained (step S2). More specifically, the discharge capacity is obtained by performing a discharge simulation while changing only the electrolyte diffusion coefficient among the characteristic parameters estimated in step S1 and keeping the other characteristic parameters constant. A discharge rate and an ambient temperature at the time of the discharge simulation are preferably set in accordance with the reuse application. For example, if the target battery is expected to be used in the application at an average rate of about 1 C, then the discharge rate used when obtaining the relationship between the electrolyte diffusion coefficient and the discharge capacity is also 1 C. Since it is difficult to precisely match all environmental conditions, simulations may be performed using average values.

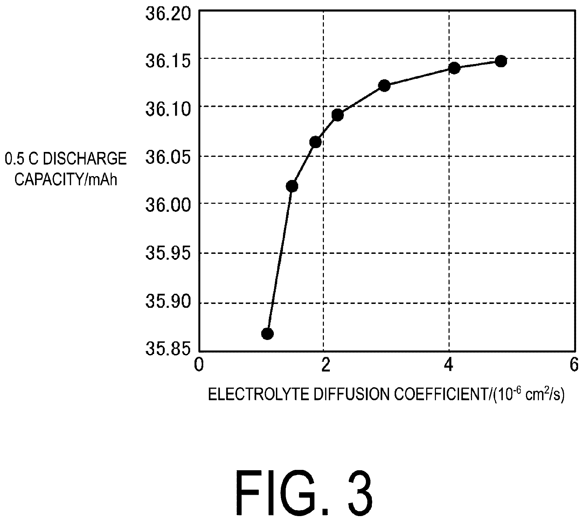

FIG. 3 is a graph showing an example of a relationship between the electrolyte diffusion coefficient and the discharge capacity. In this example, the discharge capacity with the ambient temperature set to 45°C and the discharge rate set to 0.5 C was obtained for each case in which the electrolyte diffusion coefficient was $4.8 \times 10^{-6}$, $4.0 \times 10^{-6}$, $2.95 \times 10^{-6}$, $1.85 \times 10^{-6}$, $1.48 \times 10^{-6}$, and $1.1 \times 10^{-6}$ cm²/s.

As shown in this example, generally, the smaller the electrolyte diffusion coefficient, the smaller the discharge capacity. Further, the relationship between the electrolyte diffusion coefficient and the discharge capacity is not linear, but rather has a tendency to exhibit a curve such that the decrease in discharge capacity increases as the electrolyte diffusion coefficient decreases.

Process of Determining Threshold Value Dth of Electrolyte Diffusion Coefficient

On the basis of the relationship between the electrolyte diffusion coefficient and the discharge capacity obtained in step S2, the threshold value $D_{th}$ of the electrolyte diffusion coefficient is determined (step S3). More specifically, with reference to the relationship between the electrolyte diffusion coefficient and the discharge capacity obtained in step S2, the value of the electrolyte diffusion coefficient when the target battery becomes unsuitable for reuse is determined to be the threshold value $D_{th}$. A criterion for determining that the target battery is "not suitable for reuse" differs according to the intended reuse application of the target battery. Therefore, the criterion for determining that the target battery is "not suitable for reuse" is set in accordance with the application.

For example, when the discharge capacity becomes equal to or less than a predetermined permissible value, the determination may be made that the battery is not suitable for reuse. In this case, the electrolyte diffusion coefficient when the discharge capacity becomes equal to or less than the predetermined permissible value is determined to be the threshold value $D_{th}$. For example, in the example of FIG. 3, in a case in which the permissible value of the discharge capacity is 36.02 mAh, the threshold value $D_{th}$ is $1.40 \times 10^{-6}$ cm²/s.

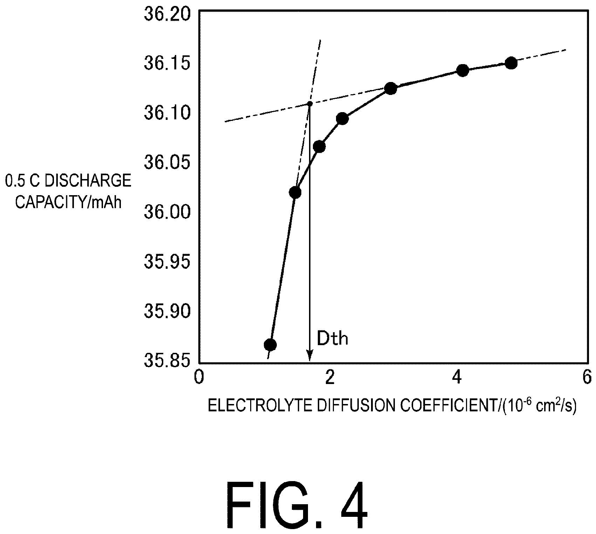

Alternatively, at the onset of a sharp drop in discharge capacity, the determination may be made that the battery is not suitable for reuse. In this case, the electrolyte diffusion coefficient at the onset of a sharp drop in discharge capacity is determined to be the threshold value $D_{th}$. For example, the electrolyte diffusion coefficient when a slope of the discharge capacity is equal to or greater than a predetermined magnitude may be set as the threshold value $D_{th}$. Further, as shown in FIG. 4, a point at which tangents of each curve before and after the onset of a sharp drop in discharge capacity intersect may be set as the threshold value $D_{th}$.

Process of Obtaining Difference ΔD between Threshold Value Dth and Electrolyte Diffusion Coefficient Dn at Time of Diagnosis

A difference $\Delta D$ between the threshold value $D_{th}$ determined in step S3 and the electrolyte diffusion coefficient $D_n$ at the time of diagnosis estimated in step S1 is obtained (step S4). For example, if $D_n = 2.22 \times 10^{-6}$ cm²/s and $D_{th} = 1.40 \times 10^{-6}$ cm²/s, then $\Delta D = D_n - D_{th} = 0.82 \times 10^{-6}$ cm²/s.

This ΔD can be used as an index for the remaining life of the target battery. That is, the target battery can be evaluated as follows: the larger the value of ΔD, the higher the likelihood the target battery can be used for a long period of time, and the smaller the value of ΔD, the lower the likelihood the target battery can be used for a long period of time. Even if the discharge capacities at the time of diagnosis are about the same, ΔD may be different. By using ΔD, it is possible to more accurately evaluate the remaining life of the target battery as compared with known methods in which the remaining life is evaluated on the basis of the magnitude of the discharge capacity at the time of diagnosis.

As described above, the life of the secondary battery greatly varies depending on usage conditions, and thus "accurate evaluation of the remaining life" does not necessarily mean prediction of a specific number of charge/discharge cycles until unsuitable for reuse. However, if it is assumed that the target battery is continuously used under certain conditions, it is also possible to predict the remaining life (number of charge/discharge cycles) of the target battery from ΔD. For example, a relationship between ΔD and the remaining life may be measured in advance, and the remaining life of the target battery may be predicted on the basis of this relationship between ΔD and the remaining life.

Second Embodiment

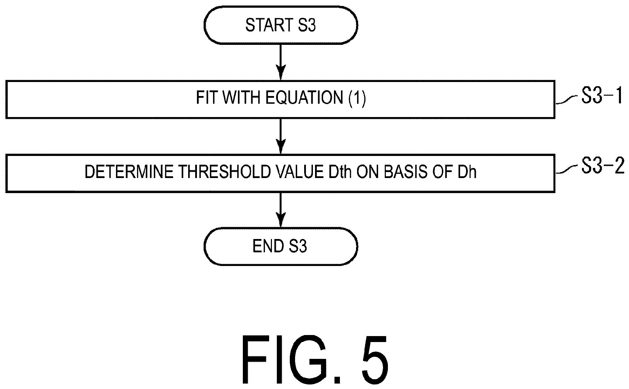

The secondary battery diagnostic method according to a second embodiment of the present invention differs from that of the first embodiment in the process of determining the threshold value Dth of the electrolyte diffusion coefficient (step S3). FIG. 5 is a flowchart illustrating a more specific procedure of the process of determining the threshold value Dth of the electrolyte diffusion coefficient (step S3) in the secondary battery diagnostic method according to the present embodiment. In the present embodiment, the process of determining the threshold value Dth of the electrolyte diffusion coefficient (step S3) includes a process of obtaining Amax, B, and Dh by fitting the relationship between the electrolyte diffusion coefficient D and the discharge capacity with equation (1) below (step S3-1), and a process of determining the threshold value Dth on the basis of Dh (step S3-2).

$$\text{Discharge capacity} = \text{Amax} - \text{B} \times \text{EXP (Dh/D)} \quad (1)$$

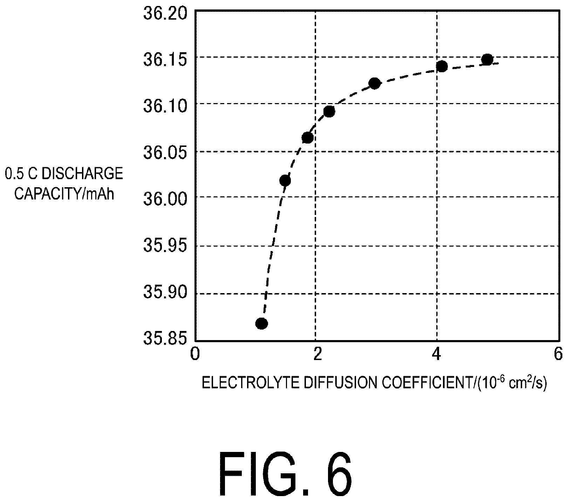

Amax, B, and Dh are obtained by fitting the relationship between the electrolyte diffusion coefficient D and the discharge capacity obtained in step S2 with equation (1) described above (step S3-1). FIG. 6 is a graph obtained by fitting the relationship between the electrolyte diffusion coefficient and the discharge capacity shown in FIG. 3 with equation (1). The dashed line in FIG. 6 represents the discharge capacity calculated by equation (1). In this example, Amax = 36.2 mAh, B = 0.034 mAh, and Dh = $2.51 \times 10^{-6}$ cm$^2$/s. As shown in FIG. 6, the relationship between the electrolyte diffusion coefficient D and the discharge capacity can be accurately approximated by equation (1).

On the basis of Dh obtained in step S3-1, the threshold value Dth is determined (step S3-2). In equation (1) described above, Dh is a parameter characterizing the value of the electrolyte diffusion coefficient at the onset of a sharp drop in discharge capacity, and it is rational to determine the threshold value Dth by using Dh as reference.

Preferably, the threshold value Dth is determined to be to a value of from 50 to 60% of Dh.

For example, in the example of FIG. 6, in a case in which the threshold value Dth is set to a value of 56% of Dh (= $2.51 \times 10^{-6}$ cm$^2$/s), the threshold value Dth is $1.40 \times 10^{-6}$ cm$^2$/s. The discharge capacity when the electrolyte diffusion coefficient is $1.40 \times 10^{-6}$ cm$^2$/s is estimated to be approximately 36.0 mAh from equation (1). This value represents a decrease within 1% from Amax (= 36.2 mAh), and looking at the absolute value of the discharge capacity, it still can be said that the discharge capacity is being maintained. On the other hand, in view of the fact that the discharge capacity decreases exponentially thereafter, by defining the value of the electrolyte diffusion coefficient of this time point as the threshold value Dth, it is possible to more reliably evaluate the reusable life. Even in a case in which there is a measurement error in the data used at the time of diagnosis or a simulation error, for example, it is possible to more reliably evaluate the reusable life.

Further, a sharp drop in discharge capacity indicates that the diffusivity of the electrolyte inside the secondary battery is insufficient, and all active materials inside the electrodes are starting to become unable to contribute to reactions. When all active materials inside the electrodes can no longer contribute to reactions, the reaction is localized, increasing the likelihood of Li deposition. That is, it can be said that the time point of the onset of a sharp drop in discharge capacity is the time point at which the likelihood of Li deposition increases. Therefore, from the viewpoint of taking into consideration the likelihood of Li deposition as well, arguably the threshold value Dth is preferably determined to be a value of from 50% to 60% of Dh.

The larger the threshold value Dth, the shorter the remaining life of the target battery is evaluated to be. Therefore, if the threshold value Dth is set to a large value, the likelihood of overestimating the remaining life decreases, but the likelihood of underestimating the remaining life increases. On the other hand, if the threshold value Dth is set to a small value, the likelihood of underestimating the remaining life decreases, but the likelihood of overestimating the remaining life increases. The threshold value Dth is more preferably a value of from 54% to 58% of Dh.

Third Embodiment

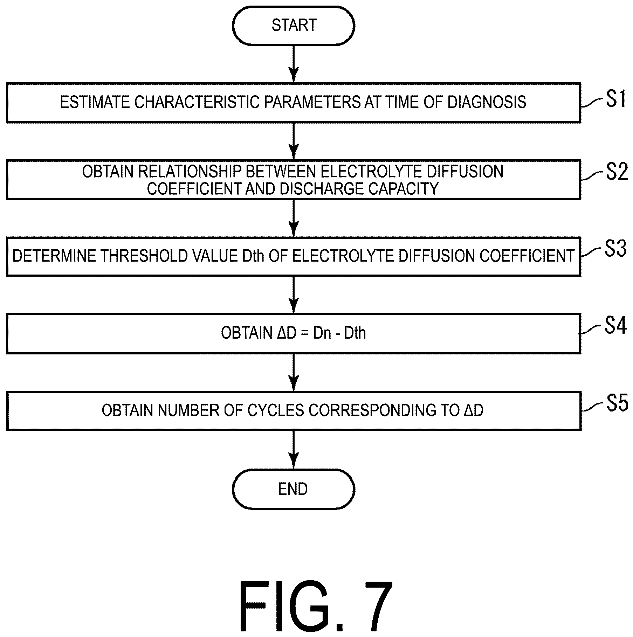

FIG. 7 is a flowchart of the secondary battery diagnostic method according to a third embodiment of the present invention. In addition to the processes included in the secondary battery diagnostic method according to the first embodiment (FIG. 1), this diagnostic method further includes a process of obtaining, on the basis of the relationship between the number of cycles and the electrolyte diffusion coefficient acquired in advance, the number of cycles corresponding to the difference $\Delta D$ (step S5).

Process of Obtaining Number of Cycles Corresponding to Difference $\Delta D$

The number of cycles corresponding to the difference $\Delta D$ is obtained on the basis of the relationship between the number of cycles and the electrolyte diffusion coefficient acquired in advance (step S5). As described above, the life of the secondary battery greatly varies depending on usage conditions, and thus the evaluation of the remaining life by the difference $\Delta D$ does not necessarily mean prediction of a specific number of charge/discharge cycles until the secondary battery becomes unsuitable for reuse. On the other hand, it has been experimentally revealed that, in a case in which the secondary battery undergoes cycle deterioration under certain conditions, the electrolyte diffusion coefficient decreases substantially linearly with respect to the number of cycles. Therefore, in a case in which it is assumed that the target battery is used under certain conditions, the relationship between the number of cycles and the electrolyte diffusion coefficient is acquired in advance, and the number of cycles described above until the difference $\Delta D$ becomes zero can be predicted on the basis of the relationship between the number of cycles and the electrolyte diffusion coefficient.

The relationship between the number of cycles and the electrolyte diffusion coefficient can be acquired, for example, as follows.

A charge/discharge cycle test is conducted on a secondary battery of the same type as that of the target battery under certain conditions to deteriorate this secondary battery. Here, a "secondary battery of the same type as that of the target battery" means a secondary battery in which the materials and shapes of the positive and negative electrodes, the type and amount of the electrolyte, and the like are equivalent to those of the target battery. For example, when the target battery is a product battery, a "secondary battery of the same type as that of the target battery" means a secondary battery or the like having the same model number. Hereinafter, this "secondary battery of the same type as that of the target battery" is referred to as a "secondary battery for measurement."

The discharge rate, the ambient temperature, and the like in the charge/discharge cycle test are preferably set in accordance with the reuse application of the target battery. For example, if the target battery is expected to be used in the application at around 1C on average, then the discharge rate used during the charge/discharge cycle test is also 1C. Since it is difficult to precisely match all environmental conditions, the charge/discharge cycle test may be conducted using average values.

With the relationship between the number of cycles and the electrolyte diffusion coefficient being linear, the charge/discharge cycle test does not need to be repeated until the secondary battery for measurement is sufficiently deteriorated, and need only be conducted until the number of cycles reaches an appropriate number.

The load characteristics of the secondary battery for measurement are measured at two or more time points having different numbers of cycles, and the characteristic parameters of the secondary battery for measurement at each time point are estimated from the data of the load characteristics. The characteristic parameters can be estimated in the same manner as in the process of estimating the characteristic parameters of the target battery (step S 1).

As described above, in a case in which the secondary battery undergoes cycle deterioration under certain conditions, the electrolyte diffusion coefficient decreases substantially linearly with respect to the number of cycles. Therefore, if the electrolyte diffusion coefficients at at least two time points are known, the relationship between the number of cycles and the electrolyte diffusion coefficient can be acquired. For example, given D1 as the value of the electrolyte diffusion coefficient when the number of cycles is n1 and D2 as the value of the electrolyte diffusion coefficient when the number of cycles is n2, a slope $k_D$ of the electrolyte diffusion coefficient with respect to the number of cycles can be obtained from $k_D = (D2 - D1)/(n2 - n1)$. Needless to say, the electrolyte diffusion coefficient may be estimated at three or more time points to obtain the slope $k_D$, thereby further reducing errors.

Note that, when the characteristic parameters at second and subsequent points are estimated, preferably, fitting is performed by changing only the discharge capacity, the electrolyte diffusion coefficient, and the electrolyte conductivity among the characteristic parameters estimated at the first point and fixing the other characteristic parameters to the characteristic parameters estimated at the first point. When estimating the characteristic parameters of second and subsequent points, the fitting may be performed by changing all characteristic parameters. However, when the fitting is performed by a person other than a skilled technician, the fitting may become inaccurate with the number of parameters, and the relationship between the number of cycles and the electrolyte diffusion coefficient may become inaccurate.

The relationship between the number of cycles and the electrolyte diffusion coefficient may be obtained by conducting a charge/discharge cycle test on the target battery itself instead of the secondary battery for measurement.

Further, after subjecting the target battery to a predetermined number of charge/discharge cycles during use, the load characteristics may be measured, and the data of these load characteristics obtained by the measurement may then be used to update the relationship between the number of cycles and the electrolyte diffusion coefficient, allowing for continuous correction of the prediction. In this case, only the load characteristics that can be measured in a short period of time, such as at 3 C and 5 C, may be acquired.

The number of cycles corresponding to the difference $\Delta D$ is obtained on the basis of the acquired relationship between the number of cycles and the electrolyte diffusion coefficient. More specifically, the number of cycles at which the difference $\Delta D$ becomes zero is obtained. The number of cycles $N_0$ at which the difference $\Delta D$ becomes zero can be obtained by $N_0 = \Delta D/|k_D|$ by using the slope $k_D$ of the electrolyte diffusion coefficient with respect to the number of cycles. This makes it possible to predict the specific number of cycles at which the target battery becomes unsuitable for reuse.

Fourth Embodiment

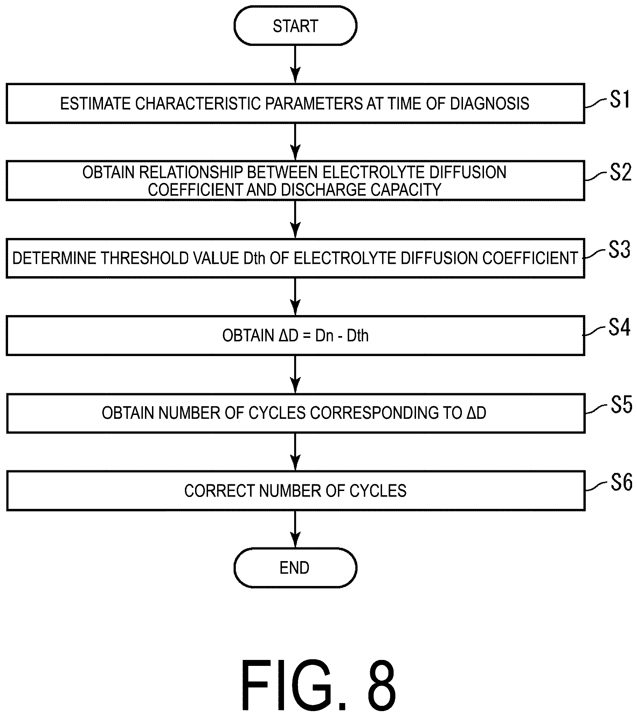

FIG. 8 is a flowchart of the secondary battery diagnostic method according to a fourth embodiment of the present invention. In addition to the processes included in the secondary battery diagnostic method according to the third embodiment (FIG. 7), this diagnostic method further includes a process of correcting the number of cycles on the basis of the relationship between the number of cycles and the threshold value of the electrolyte diffusion coefficient acquired in advance (step S6).

Process of Correcting Number of Cycles

The number of cycles obtained in step S5 (number of cycles $N_0$ corresponding to the difference $\Delta D$) is corrected on the basis of the relationship between the number of cycles and the threshold value of the electrolyte diffusion coefficient acquired in advance (step S6). As described above, it has been experimentally revealed that the threshold value of the electrolyte diffusion coefficient changes substantially linearly with respect to the number of cycles. Taking this into consideration, by predicting the time point at which the electrolyte diffusion coefficient falls below the threshold value Dth, it is possible to predict, with higher accuracy, the specific number of cycles at which the target battery becomes unsuitable for reuse.

The relationship between the number of cycles and the threshold value Dth of the electrolyte diffusion coefficient can be acquired as follows, for example.

As when obtaining the relationship between the number of cycles and the electrolyte diffusion coefficient, a charge/discharge cycle test is conducted on the secondary battery for measurement under certain conditions to deteriorate the secondary battery for measurement. The load characteristics of the secondary battery for measurement are measured at two or more time points having different numbers of cycles, and the characteristic parameters of the secondary battery for measurement at each time point are estimated from the data of the load characteristics. As the data of the load characteristics and the characteristic parameters, those acquired when the relationship between the number of cycles and the electrolyte diffusion coefficient was obtained may be used.

The relationship between the electrolyte diffusion coefficient and the discharge capacity is obtained at each time point by using these characteristic parameters, and the threshold value of the electrolyte diffusion coefficient at each time point is then determined. These processes can be performed as in the process of obtaining the relationship between the electrolyte diffusion coefficient and the discharge capacity of the target battery (step S2) and the process of determining the threshold value Dth of the electrolyte diffusion coefficient of the target battery (step S3).

In a case in which the secondary battery undergoes cycle deterioration under certain conditions, the threshold value of the electrolyte diffusion coefficient changes substantially linearly with respect to the number of cycles. Therefore, if the threshold values of the electrolyte diffusion coefficient at at least two time points are known, the relationship between the number of cycles and the threshold value of the electrolyte diffusion coefficient can be acquired. For example, given Dth1 as the threshold value of the electrolyte diffusion coefficient when the number of cycles is n1 and Dth2 as the threshold value of the electrolyte diffusion coefficient when the number of cycles is n2, a slope $k_{th}$ of the threshold value of the electrolyte diffusion coefficient with respect to the number of cycles can be obtained by $k_{th} = (Dth2 - Dth1)/(n2 - n1)$. Needless to say, the threshold value of the electrolyte diffusion coefficient may be determined at three or more time points to obtain the slope $k_{th}$, thereby further reducing errors.

As when obtaining the relationship between the number of cycles and the electrolyte diffusion coefficient, the relationship between the number of cycles and the threshold value of the electrolyte diffusion coefficient may be obtained by conducting a charge/discharge cycle test on the target battery itself instead of the secondary battery for measurement.

The number of cycles obtained in step S5 is corrected on the basis of the acquired relationship between the number of cycles and the threshold value of the electrolyte diffusion coefficient. In a case in which the electrolyte diffusion coefficient changes with the slope $k_D$ with respect to the number of cycles, an electrolyte diffusion coefficient D' after N cycles from the time of diagnosis is $D' = Dn + k_D \times N$. Similarly, in a case in which the threshold value of the electrolyte diffusion coefficient changes with the slope $k_{th}$ with respect to the number of cycles, a threshold value Dth' after N cycles from the time of diagnosis is Dth' = Dth + $k_{th}$ × N. The number of cycles Ni at which D' and Dth' become equal can be obtained by $N_1$ = (Dn - Dth)/($k_{th}$ - $k_D$). This makes it possible to predict the specific number of cycles at which the target battery becomes unsuitable for reuse with higher accuracy.

Secondary Battery Diagnostic Program and the Like

The secondary battery diagnostic method described above can also be realized as a computer program. A secondary battery diagnostic program according to an embodiment of the present invention is a secondary battery diagnostic program for causing a computer to execute estimating, on the basis of data obtained by measuring load characteristics of a secondary battery to be diagnosed, characteristic parameters of the secondary battery to be diagnosed at a time of diagnosis by using a predetermined model equation, the characteristic parameters including the electrolyte diffusion coefficient Dn of the secondary battery to be diagnosed at the time of diagnosis; obtaining, on the basis of the model equation and the characteristic parameters estimated, a discharge capacity when an electrolyte diffusion coefficient is changed, and obtaining a relationship between the electrolyte diffusion coefficient and the discharge capacity; determining, on the basis of the relationship between the electrolyte diffusion coefficient and the discharge capacity, the threshold value Dth of the electrolyte diffusion coefficient; and obtaining the difference ΔD between the threshold value Dth and the electrolyte diffusion coefficient Dn at the time of diagnosis. According to the present embodiment as well, it is possible to more accurately evaluate the remaining life of the target battery as compared with known methods in which the remaining life is evaluated on the basis of the magnitude of the discharge capacity at the time of diagnosis.

The computer program of a form corresponding to the secondary battery diagnostic method according to the first embodiment has been described above, However, the secondary battery diagnostic methods according to the second to fourth embodiments can also be realized as computer programs.

The secondary battery electrode diagnostic methods described above can also be realized as computer-readable recording media in which the computer program described above is recorded.

The secondary battery diagnostic methods described above can also be realized as computer systems. A secondary battery diagnostic system according to an embodiment of the present invention includes a memory and a processor, and the processor, according to a program in the memory, executes estimating, on the basis of data obtained by measuring load characteristics of a secondary battery to be diagnosed, characteristic parameters of the secondary battery to be diagnosed at a time of diagnosis by using a predetermined model equation, the characteristic parameters including the electrolyte diffusion coefficient Dn of the secondary battery to be diagnosed at the time of diagnosis; obtaining, on the basis of the model equation and the characteristic parameters estimated, a discharge capacity when an electrolyte diffusion coefficient is changed, and obtaining a relationship between the electrolyte diffusion coefficient and the discharge capacity; determining, on the basis of the relationship between the electrolyte diffusion coefficient and the discharge capacity, the threshold value Dth of the electrolyte diffusion coefficient; and obtaining the difference ΔD between the threshold value Dth and the electrolyte diffusion coefficient Dn at the time of diagnosis.

Examples

Hereinafter, the present invention will be described more specifically with reference to examples. The present invention is not limited to these examples.

A plurality of medium-sized laminate-type cells having a rated capacity of 5 Ah and a plurality of small-sized laminate-type cells having a rated capacity of 36 mAh were fabricated.

Medium-Sized Laminate-Type Cell

Fabrication of Positive Electrode

A positive-electrode-mixture-containing slurry was prepared by uniformly mixing 93 parts by mass of $LiCoO_2$ as a positive electrode active material, 3 parts by mass of carbon black as a conductive aid, and 4 parts by mass of polyvinylidene fluoride (PVDF) as a binder, using N-methyl-2-pyrrolidone (NMP) as a solvent. This positive-electrode-mixture-containing slurry was applied to both sides of a positive electrode current collector made of aluminum foil having a thickness of 15 μm, dried, subsequently pressure-formed using a roller press machine, and then punched out so that a portion of the positive electrode current collector not coated with the positive-electrode-mixture-containing slurry became a tab portion, thereby fabricating the positive electrode.

Fabrication of Negative Electrode

A negative-electrode-mixture-containing slurry was prepared by mixing 97.5 parts by mass of graphite as a negative electrode active material, 1.5 parts by mass of carboxymethyl cellulose as a binder, and 1 part by mass of styrene-butadiene rubber, and then adding an appropriate amount of water and thoroughly mixing. This negative-electrode-mixture-containing slurry was applied to both sides of a negative electrode current collector made of copper foil having a thickness of 10 $\mu$m, dried, subsequently pressure-formed using a roller press machine, and then punched out so that a portion of the negative electrode current collector not coated with the negative-electrode-mixture-containing slurry became a tab portion, thereby fabricating the negative electrode.

Fabrication of Battery

Seven of the positive electrodes described above and eight of the negative electrodes described above were alternately layered with a polyolefin microporous film separator interposed therebetween to form a multilayer electrode body, the polyolefin microporous film separator having a thickness of 18 $\mu$m and a three-layer structure consisting of a polyethylene layer as a middle layer and two polypropylene layers as outer layers.

Next, the tab portions of the positive electrodes of the multilayer electrode body were welded together and the tab portions of the negative electrodes of the multilayer electrode body were welded together and leads were connected respectively thereto. Then, the multilayer electrode body was enclosed inside an outer packaging made from an aluminum laminate film together with a non-aqueous electrolyte prepared by dissolving $LiPF_6$ at a concentration of 1 mol/L in a solution obtained by mixing ethylene carbonate, diethyl carbonate, and methyl ethyl carbonate at a volume ratio of 1:1:1, and further dissolving vinylene carbonate in an amount of 1 mass%, thereby fabricating a non-aqueous electrolyte secondary battery with a rated capacity of 5 Ah.

Small-Sized Laminate-Type Cell

Fabrication of Positive Electrode

A positive-electrode-mixture-containing slurry was prepared by uniformly mixing 94 parts by mass of $LiCoO_2$ as the positive electrode active material, 4 parts by mass of carbon black as the conductive aid, and 2 parts by mass of PVDF as the binder, using NMP as the solvent. This positive-electrode-mixture-containing slurry was applied to both sides of a positive electrode current collector made of aluminum foil having a thickness of 15 $\mu$m, dried, subsequently pressure-formed using a roller press machine, and then punched out so that a portion of the positive electrode current collector not coated with the positive-electrode-mixture-containing slurry became a tab portion, thereby fabricating the positive electrode.

Fabrication of Negative Electrode

A negative-electrode-mixture-containing slurry was prepared by mixing 94.5 parts by mass of graphite and 3 parts by mass of SiO particles (D50: 5.0 $\mu$m) including a front surface coated with carbon as the negative electrode active material, 1.5 parts by mass of carboxymethyl cellulose and 1 part by mass of styrene-butadiene rubber as the binder, and then adding an appropriate amount of water and thoroughly mixing. This negative-electrode-mixture-containing slurry was applied to both sides of a negative electrode current collector made of copper foil having a thickness of 10 $\mu$m, dried, subsequently pressure-formed using a roller press machine, and then punched out so that a portion of the negative electrode current collector not coated with the negative-electrode-mixture-containing slurry became a tab portion, thereby fabricating the negative electrode.

Fabrication of Battery

The positive electrode described above and the negative electrode described above were layered with a polyolefin microporous film separator interposed therebetween to form a multilayer electrode body, the polyolefin microporous film separator having a thickness of 12 $\mu$m and a three-layer structure consisting of a polyethylene layer as the middle layer and two polypropylene layers as the outer layers.

Next, leads were respectively connected to the tab portion of the positive electrode and the tab portion of the negative electrode of the multilayer electrode body. Then, the multilayer electrode body was enclosed inside an outer packaging made from an aluminum laminate film together with a non-aqueous electrolyte prepared by dissolving $LiPF_6$ at a concentration of 1 mol/L in a solution obtained by mixing ethylene carbonate and diethyl carbonate at a volume ratio of 3:7, and further dissolving vinylene carbonate in an amount of 1 mass%, thereby fabricating a non-aqueous electrolyte secondary battery with a rated capacity of 36 mAh.

Fabrication of Deteriorated Cells

A plurality of deteriorated cells having discharge capacities reduced to 4.8 Ah were fabricated by conducting charge/discharge cycle tests on the medium-sized laminate-type cells having a rated capacity of 5 Ah under a plurality of conditions different in terms of charge/discharge rate, ambient temperature, and the like. Similarly, a plurality of deteriorated cells having discharge capacities reduced to 35 mAh were fabricated by conducting charge/discharge cycle tests on the small-sized laminate-type cells having a rated capacity of 36 mAh under a plurality of conditions different in charge/discharge rate, ambient temperature, and the like.

Measurement of Load Characteristics

The load characteristics of these deteriorated cells were measured. Specifically, discharge curves were measured at discharge rates of 0.02 C, 0.2 C, 0.5 C, and 1 C.

Diagnosis of Secondary Battery

The secondary battery diagnostic method described in the embodiment was carried out using these deteriorated cells as target batteries. The analysis (simulation) was carried out by the software Battery Design Studio available from Siemens AG. Among the basic specifications, a solvent ratio and a salt concentration were input using the same values as those at the time of fabrication (because the values at the time of diagnosis cannot be measured).

The relationship between the electrolyte diffusion coefficient and the discharge capacity was acquired by estimating the characteristic parameters at the time of diagnosis and subsequently, on the basis of the estimated characteristic parameters, obtaining the discharge capacity at an ambient temperature of 45°C and a discharge rate of 0.5 C while changing the electrolyte diffusion coefficient. The difference $\Delta D$ between the threshold value Dth and the electrolyte diffusion coefficient Dn at the time of diagnosis was obtained with the point at which tangents of each curve before and after the onset of a sharp drop in discharge capacity intersect defined as the threshold value Dth.

Measurement of Remaining Life

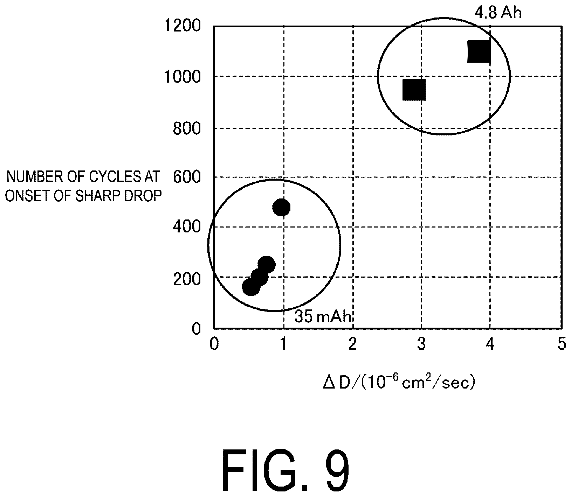

These deteriorated cells were subjected to charge/discharge cycle tests under the same conditions, and the number of charge/discharge cycles until a sharp drop in discharge capacity occurred (number of cycles at the onset of a sharp drop) was measured. FIG. 9 shows the relationship between $\Delta D$ obtained by the diagnosis and the number of cycles at the onset of a sharp drop. Note that FIG. 9 excludes the data of a cell in which Li deposition described below occurred in the charge/discharge cycle test.

As shown in FIG. 9, even when the discharge capacities at the time of diagnosis were equivalent (4.8 Ah or 35 mAh), a difference in $\Delta D$ was confirmed. Further, the number of cycles at the onset of a sharp drop was found to also change in accordance with $\Delta D$, confirming the validity of this diagnostic method.

Setting of Threshold Value Dth Using Equation (1)

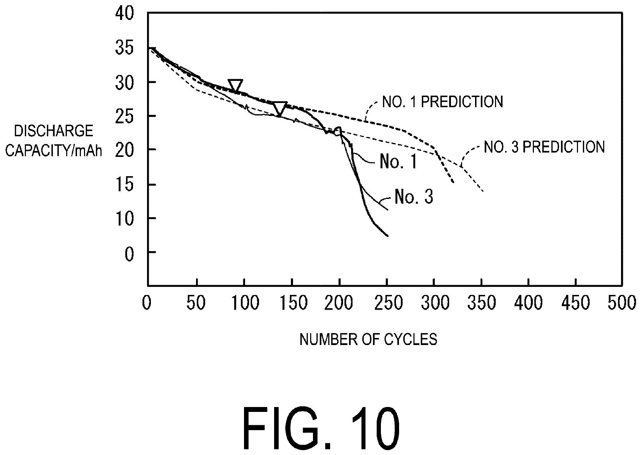

FIG. 10 is a graph illustrating the relationship between the number of cycles and the discharge capacity of two cells (Cell No. 1 and Cell No. 3) in which Li deposition occurred. The solid line represents actual measurement data, and the dashed line represents predicted values by simulation.

Specifically, the predicted values by simulation were calculated as follows.

The load characteristics of the deteriorated cell were measured during the charge/discharge cycle test, and an electrolyte diffusion coefficient Dm during the charge/discharge cycle test was estimated by the same method as that for estimating Dn. Under the assumption that the electrolyte diffusion coefficient linearly decreases with respect to the number of cycles, the electrolyte diffusion coefficient DN after N cycles was expressed by equation (2) below. The value of DN obtained from equation (2) was substituted for D in equation (1) to obtain the discharge capacity C(N) after N cycles. The discharge capacity C(N) after N cycles was divided by the initial discharge capacity C(0) to obtain a capacity retention rate q(N) = C(N)/C(0) after N cycles.

$$DN = (Dm - Dn)/m \times N + Dn \ (2)$$

Here, m is the number of cycles when Dm is estimated.

In the case of cycle deterioration, in addition to a decrease in discharge capacity due to a decrease in liquid diffusivity, a decrease in discharge capacity in accordance with the root law occurs as steady deterioration. Of the actual measurement data, data before a sharp drop in discharge capacity occurred was fitted with equation (3) below to obtain a discharge capacity R(N) after N cycles in accordance with the root law. The predicted value from the simulation was obtained by multiplying this discharge capacity R(N) by the capacity retention rate q(N) described above.

$$R(N) = C(0) - r \times N^{1/2} \ (3)$$

Here, r is a parameter obtained by fitting.

The predicted value by simulation corresponds to a change in discharge capacity in a case in which Li deposition does not occur. In the actual measurement data, due to Li deposition, a sharp drop in discharge capacity occurs at a time point earlier than the predicted value.

The triangular mark in FIG. 10 indicates a time point at which the electrolyte diffusion coefficient becomes 56% of Dh. In the actual measurement data, shortly after the time point when the electrolyte diffusion coefficient reaches 56% of the value of Dh, the discharge capacity becomes unstable, and Li deposition begins to occur.

Cells in which Li deposition does not occur can be used for a longer period. However, taking into consideration the likelihood of Li deposition, it can be said that the threshold value Dth of the electrolyte diffusion coefficient is desirably set to a value of from 50% to 60% of Dh.

Relationship between Number of Cycles and Electrolyte Diffusion Coefficient

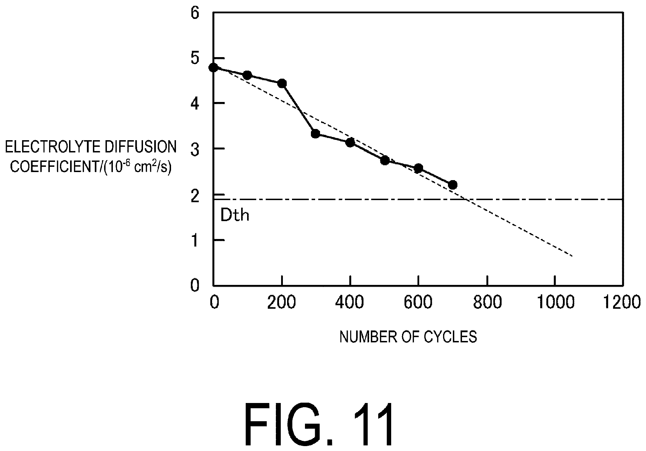

For deteriorated cells having a discharge capacity of 4.8 Ah, the load characteristics were measured every 100 cycles during the charge/discharge cycle test, and the electrolyte diffusion coefficient at each time point was estimated by using the same method as that used to estimate Dn. FIG. 11 is a graph showing the relationship between the number of cycles and the electrolyte diffusion coefficient. The alternate long and short dashed line indicates the threshold value Dth of the electrolyte diffusion coefficient.

As shown in FIG. 11, it can be seen that the electrolyte diffusion coefficient decreases substantially linearly with respect to the number of cycles. Furthermore, in FIG. 11, at the time point of 700 cycles, $\Delta D$ is only $0.3 \times 10^{-6}$ cm$^2$/s and, when the change in the electrolyte diffusion coefficient is subsequently extrapolated, it is possible to predict the onset of a sharp drop, that is, the onset of deviation from the root law, around approximately 800 cycles.

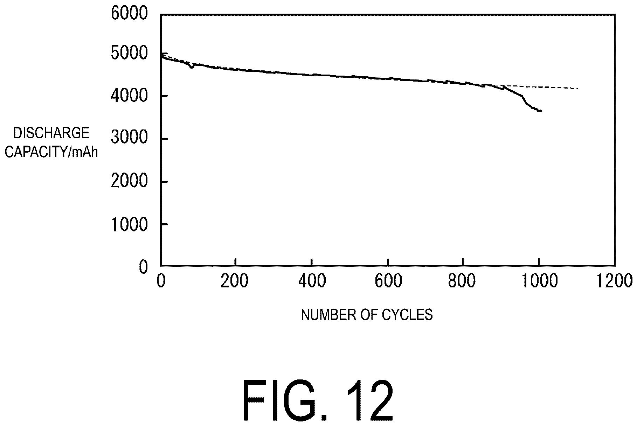

FIG. 12 is a graph showing the results of the cycle test of the deteriorated cell used for estimation in FIG. 11. The solid line is the actual measurement value, and the dashed line is a line showing a cycle curve based on the root law. As shown in FIG. 12, it was confirmed that onset of deviation from the root law occurred after about 900 cycles and, although there was a slight prediction error, a sharp drop actually occurred.

In the related art, a method for predicting the "sharp drop" deviating from the root law in terms of the "number" of cycles is nonexistent, making this technique a completely novel technique. Furthermore, the predicted number of cycles deviates only by about 100 cycles from the final life of approximately 1000 cycles, indicating that the prediction is generally valid.

Relationship between Number of Cycles and Threshold Value of Electrolyte Diffusion Coefficient

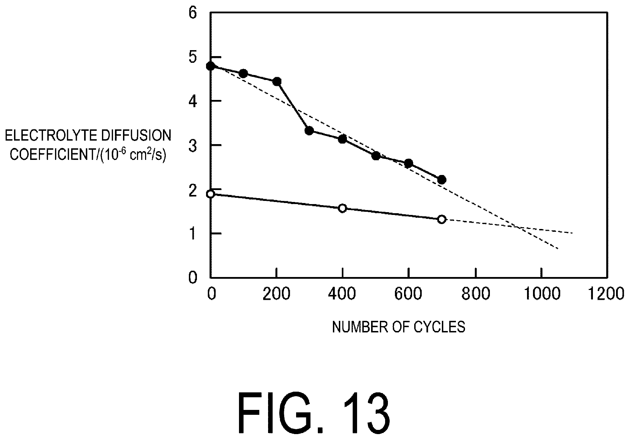

Next, the relationship between the electrolyte diffusion coefficient and the discharge capacity was obtained from the characteristic parameters estimated at 400 cycles and at 700 cycles, and the threshold value of the electrolyte diffusion coefficient was obtained at 400 cycles and at 700 cycles. FIG. 13 is a graph obtained by adding the relationship between the number of cycles and the threshold value of the electrolyte diffusion coefficient to the graph of FIG. 11. The unfilled marks in the graph are the threshold values of the electrolyte diffusion coefficient.

As shown in FIG. 13, it can be seen that the threshold value of the electrolyte diffusion coefficient also decreases substantially linearly with respect to the number of cycles, as with the electrolyte diffusion coefficient. It can be predicted that the line obtained by extrapolating the change in the electrolyte diffusion coefficient and the line obtained by extrapolating the change in the threshold value of the electrolyte diffusion coefficient will intersect at the time point of approximately 900 cycles. This is in favorable agreement with the number of cycles at the onset of deviation from the root law in FIG. 12. These prediction results were found to reproduce the actually measured cycle capacity decrease with great accuracy and found to be valid.

Although embodiments of the present invention have been described above, the present invention is not limited to the above-described embodiments, and various modifications can be made within the scope of the invention.

**Claims**

1. A secondary battery diagnostic method comprising:

   estimating, on the basis of data obtained by measuring load characteristics of a secondary battery to be diagnosed, characteristic parameters of the secondary battery to be diagnosed at a time of diagnosis by using a predetermined model equation, the characteristic parameters including an electrolyte diffusion coefficient Dn of the secondary battery to be diagnosed at the time of diagnosis;
   obtaining, on the basis of the model equation and the characteristic parameters estimated, a discharge capacity when an electrolyte diffusion coefficient is changed, and obtaining a relationship between the electrolyte diffusion coefficient and the discharge capacity;
   determining, on the basis of the relationship between the electrolyte diffusion coefficient and the discharge capacity, a threshold value Dth of the electrolyte diffusion coefficient; and
   obtaining a difference ΔD between the threshold value Dth and the electrolyte diffusion coefficient Dn at the time of diagnosis.

2. The secondary battery diagnostic method according to claim 1, wherein
   in the determination of the threshold value Dth, an electrolyte diffusion coefficient when the discharge capacity is a predetermined permissible value or less is determined to be the threshold value Dth.

3. The secondary battery diagnostic method according to claim 1, wherein
   in the determination of the threshold value Dth, an electrolyte diffusion coefficient at the onset of a sharp drop in the discharge capacity is determined to be the threshold value Dth.

4. The secondary battery diagnostic method according to claim 1, wherein

   the determination of the threshold value Dth includes
   obtaining Amax, B, and Dh by fitting the relationship between the electrolyte diffusion coefficient D and the discharge capacity with equation (1) below, and
   determining the threshold value Dth on the basis of the Dh

$$\text{Discharge capacity} = A_{max} - B \times EXP(D_h/D) \quad (1)$$

5. The secondary battery diagnostic method according to claim 4, wherein
   the threshold value Dth is set to a value of from 50% to 60% of the Dh.

6. The secondary battery diagnostic method according to any one of claims 1 to 5, further comprising:
   predicting, on the basis of a relationship between the difference ΔD and a remaining life measured in advance, a remaining life of the secondary battery to be diagnosed.

7. The secondary battery diagnostic method according to any one of claims 1 to 5, further comprising:
   obtaining, on the basis of a relationship between the number of cycles and the electrolyte diffusion coefficient acquired in advance, the number of cycles corresponding to the difference ΔD.

8. The secondary battery diagnostic method according to claim 7, wherein
   the number of cycles corresponding to the difference ΔD is obtained by approximating the relationship between the number of cycles and the electrolyte diffusion coefficient by a straight line.

9. The secondary battery diagnostic method according to claim 7, wherein
   the relationship between the number of cycles and the electrolyte diffusion coefficient is acquired from data obtained for a secondary battery of an identical type to the secondary battery to be diagnosed.

10. The secondary battery diagnostic method according to claim 7, wherein
    the relationship between the number of cycles and the electrolyte diffusion coefficient is acquired from data obtained for the secondary battery to be diagnosed.

11. The secondary battery diagnostic method according to claim 7, further comprising:

correcting the number of cycles corresponding to the difference $\Delta D$ on the basis of a relationship between the number of cycles and a threshold value of the electrolyte diffusion coefficient acquired in advance.

12. The secondary battery diagnostic method according to claim 11, wherein
    the number of cycles corresponding to the difference $\Delta D$ is corrected by approximating the relationship between the number of cycles and the threshold value of the electrolyte diffusion coefficient by a straight line.

13. The secondary battery diagnostic method according to any one of claims 1 to 5, wherein
    the data obtained by measuring the load characteristics includes a discharge curve obtained by measuring the secondary battery to be diagnosed at a plurality of discharge rates.

14. The secondary battery diagnostic method according to any one of claims 1 to 5, wherein
    the secondary battery to be diagnosed is a lithium ion battery.

15. A secondary battery diagnostic program for causing a computer to execute:

    estimating, on the basis of data obtained by measuring load characteristics of a secondary battery to be diagnosed, characteristic parameters of the secondary battery to be diagnosed at a time of diagnosis by using a predetermined model equation, the characteristic parameters including an electrolyte diffusion coefficient $Dn$ of the secondary battery to be diagnosed at the time of diagnosis;
    obtaining, on the basis of the model equation and the characteristic parameters estimated, a discharge capacity when an electrolyte diffusion coefficient is changed, and obtaining a relationship between the electrolyte diffusion coefficient and the discharge capacity;
    determining, on the basis of the relationship between the electrolyte diffusion coefficient and the discharge capacity, a threshold value $Dth$ of the electrolyte diffusion coefficient; and
    obtaining a difference $\Delta D$ between the threshold value $Dth$ and the electrolyte diffusion coefficient $Dn$ at the time of diagnosis.

START

ESTIMATE CHARACTERISTIC PARAMETERS AT TIME OF DIAGNOSIS — S1

OBTAIN RELATIONSHIP BETWEEN ELECTROLYTE DIFFUSION COEFFICIENT AND DISCHARGE CAPACITY — S2

DETERMINE THRESHOLD VALUE Dth OF ELECTROLYTE DIFFUSION COEFFICIENT — S3

OBTAIN $\Delta D = Dn - Dth$ — S4

END

# FIG. 1

START S1

INPUT BASIC SPECIFICATIONS OF TARGET BATTERY — S1-1

INPUT DATA OBTAINED BY MEASURING LOAD CHARACTERISTICS — S1-2

ESTIMATE STATIC PARAMETERS OF TARGET BATTERY — S1-3

ESTIMATE DYNAMIC PARAMETERS OF TARGET BATTERY — S1-4

END S1

# FIG. 2

0.5 C DISCHARGE CAPACITY/mAh

ELECTROLYTE DIFFUSION COEFFICIENT/($10^{-6}$ cm²/s)

# FIG. 3

FIG. 4

START S3

FIT WITH EQUATION (1) — S3-1

DETERMINE THRESHOLD VALUE Dth ON BASIS OF Dh — S3-2

END S3

# FIG. 5

**0.5 C DISCHARGE CAPACITY/mAh** (y-axis)

**ELECTROLYTE DIFFUSION COEFFICIENT/($10^{-6}$ cm²/s)** (x-axis)

# FIG. 6

START

ESTIMATE CHARACTERISTIC PARAMETERS AT TIME OF DIAGNOSIS — S1

OBTAIN RELATIONSHIP BETWEEN ELECTROLYTE DIFFUSION COEFFICIENT AND DISCHARGE CAPACITY — S2

DETERMINE THRESHOLD VALUE Dth OF ELECTROLYTE DIFFUSION COEFFICIENT — S3

OBTAIN $\Delta D = Dn - Dth$ — S4

OBTAIN NUMBER OF CYCLES CORRESPONDING TO $\Delta D$ — S5

END

# FIG. 7

START

ESTIMATE CHARACTERISTIC PARAMETERS AT TIME OF DIAGNOSIS — S1

OBTAIN RELATIONSHIP BETWEEN ELECTROLYTE DIFFUSION COEFFICIENT AND DISCHARGE CAPACITY — S2

DETERMINE THRESHOLD VALUE Dth OF ELECTROLYTE DIFFUSION COEFFICIENT — S3

OBTAIN $\Delta D = Dn - Dth$ — S4

OBTAIN NUMBER OF CYCLES CORRESPONDING TO $\Delta D$ — S5

CORRECT NUMBER OF CYCLES — S6

END

# FIG. 8

FIG. 9

FIG. 10

FIG. 11

DISCHARGE
CAPACITY/mAh

NUMBER OF CYCLES

# FIG. 12

FIG. 13

**EP 4 478 482 A1**

## INTERNATIONAL SEARCH REPORT

International application No.

**PCT/JP2023/003516**

### A. CLASSIFICATION OF SUBJECT MATTER

*H01M 10/48*(2006.01)i; *G01R 31/367*(2019.01)i; *G01R 31/392*(2019.01)i; *H01M 10/44*(2006.01)i
FI:   H01M10/48 P; G01R31/367; G01R31/392; H01M10/44 Q

According to International Patent Classification (IPC) or to both national classification and IPC

### B. FIELDS SEARCHED

Minimum documentation searched (classification system followed by classification symbols)

H01M10/48; G01R31/367; G01R31/392; H01M10/44

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2017-97997 A (HITACHI MAXELL, LTD.) 01 June 2017 (2017-06-01)<br>entire text, all drawings | 1-15 |
| A | JP 2010-60406 A (TOYOTA MOTOR CORP.) 18 March 2010 (2010-03-18)<br>entire text, all drawings | 1-15 |

☐ Further documents are listed in the continuation of Box C.       ☑ See patent family annex.

| | | |
|---|---|---|
| * | Special categories of cited documents: | "T"   later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X"   document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&"   document member of the same patent family |

| Date of the actual completion of the international search | Date of mailing of the international search report |
|---|---|
| **04 April 2023** | **25 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

International application No.

**PCT/JP2023/003516**

| Patent document cited in search report | | | Publication date (day/month/year) | Patent family member(s) | Publication date (day/month/year) |
|---|---|---|---|---|---|
| JP | 2017-97997 | A | 01 June 2017 | (Family: none) | |
| JP | 2010-60406 | A | 18 March 2010 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017097997 A

**Non-patent literature cited in the description**

- **MARC DOYLE et al.** Modeling of Galvanostatic Charge and Discharge of the Lithium/Polymer/Insertion Cell. *J. Electrochem. Soc.*, June 1993, vol. 140 (6)